# EUROPEAN PATENT APPLICATION

(11) **EP 1 780 601 A2**
(43) Date of publication of application: **02.05.2007**
(21) Application number: 06076942.9
(22) Date of filing: 27.10.2006
(51) Int. Cl.: G03F 7/20

(54) **Lithographic apparatus and device manufacturing method**

(30) Priority: 28.10.2005 US 730885 P
(71) Applicant: ASML Netherlands B.V., 5504 DR Veldhoven (NL)
(72) Inventor: Zaal, Koen Jacobus Johannes Maria, 5611 JB Eindhoven (NL); Ottens, Joost Jeroen, 5501 BG Veldhoven (NL); van den Akker, Jeroen, 5052 BH Goirle (NL)
(74) Representative: van Loon, C.J.J.

(57) **Abstract**

The invention relates to an article support member configured to support an article to be placed in a beam path of a radiation beam of a lithographic apparatus on said article support; said article support member comprising: a base plate of a first material; and a plurality of burls of a second material, bonded to said base plate of said first material.

## Description

### FIELD

The present invention relates to a lithographic apparatus and a method for manufacturing a device. Specifically, the invention relates to a lithographic apparatus comprising an article support member configured to support an article to be placed in a beam path of radiation of said lithographic apparatus and to a method for manufacturing thin laminated structures, in particular, a method for manufacturing an article support member for a lithographic apparatus.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In the lithographic apparatus as hereabove specified, an article to be placed in the radiation beam is held to an article support member, for example, by a clamping electrode, by vacuum suction or otherwise. Electrostatic clamping may be used for example when a substrate is processed in vacuum conditions. This type of processing occurs for instance when the type of irradiation used for photolithographic processes is in the (soft) x-ray region, also referred to as Extreme Ultraviolet (EUV) region.

Currently such article support members are typically from a variety of rigid materials, for instance a material known in the art as ULE, Zerodur, Cordierite or Sapphire material, or other rigid materials, such as ceramic materials or crystalline materials. These materials are chosen among others for good mechanical stability and heat conductivity and reduced thermal expansion properties.

Typically, for these materials, a number of mechanical and material properties are considered important, and where typically one material has a better mechanical stability, it may have relatively less favourable thermal expansion properties compared to another material. In particular, the Cordierite, Zerodur and ULE materials, hereinafter also indicated as materials of a first group, do have very good thermal characteristics, in that they have a CTE (Coefficient of Thermal Expansion) of practically zero. This makes these materials attractive for using as wafer table materials, since (local) heating of these materials does not give rise to significant distortions, which can result in a deteriorated focus and/or overlay of the images projected on a target portion of a substrate. However, the wear characteristics of these materials are such that the economic lifetime of these article supports is significantly limited in comparison with other materials that are known, such as SiSiC or SiC, hereinafter indicated as materials of a second group, but which do possess less favourable thermal characteristics. However, combining a layer of the first material with a layer of a second material is not straightforward since it would give rise to bimetal-like bending effects when subject to temperature variations.

Hence, a desire arises to provide a material that combines the best of these characteristics in one.

In the context of this application, the said "article" may be any of the above mentioned terms wafer, reticle, mask, or substrate, more specifically terms such as
- a substrate to be processed in manufacturing devices employing lithographic projection techniques; or
- a lithographic projection mask or mask blank in a lithographic projection apparatus, a mask handling apparatus such as mask inspection or cleaning apparatus, or a mask manufacturing apparatus or any other article or optical element that is clamped in the light path of the radiation system.

### SUMMARY

In one aspect, it is desirable to provide an article support member that is more robust and less sensitive to temperature during the manufacturing process thereof. In another aspect, it is desirable to provide an article support member that has an improved wear resistance.

According to an aspect of the invention, there is provided a lithographic apparatus according to the features of claim 1. Specifically, according to the invention, there is provided an article support member configured to support an article to be placed in a beam path of a radiation beam of a lithographic apparatus on said article support; said article support member comprising a base plate of a first material; and a plurality of burls of a second material, bonded to said base plate of said first material.

In another aspect of the invention there is provided a method of manufacturing an article support member, comprising: providing a base plate having a flat surface; providing a burl plate comprising a plate having a plurality of burls formed to provide a flat top surface; bonding said flat top surface of said burl plate to said base plate; and removing the plate of the burl plate thus leaving the burls of the burl plate bonded to the base plate.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a lithographic apparatus according to an embodiment of the invention; and
Figure 2 shows schematically the steps for manufacturing an article support member according to the invention.

### DETAILED DESCRIPTION

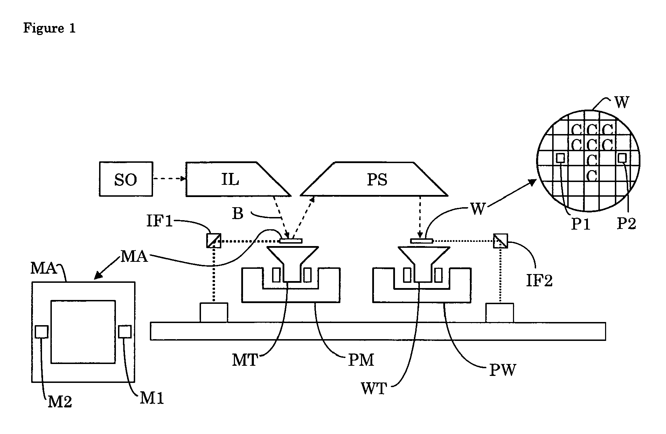

Figure 1 schematically depicts a lithographic apparatus according to one embodiment of the invention. The apparatus comprises:
- an illumination system (illuminator) IL configured to condition a radiation beam B (e.g. UV radiation or EUV radiation).
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WT constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a reflective type (e.g. employing a reflective mask). Alternatively, the apparatus may be of a transmissive type (e.g. employing a transmissive mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF2 (e.g. an interferometric device, linear encoder or capacitive sensor), the substrate table WT can be moved accurately, e.g. so as to position different target portions C in the path of the radiation beam B. Similarly, the first positioner PM and another position sensor IF1 can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:
1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

Designing article supports such as wafer tables or reticle supports in a lithographic system, is a very critical process. In the remaining the embodiments will be referred to as wafer tables, although it has to be understood that these embodiments can also referred to as the more general indication of "article supports" or "article support members". Specifically, in the context of this invention, the article supports can form any support for placing an article in a beam of radiation, be it a wafer, a mask or a fiducial reticle.

Conventionally, the wafer table is provided with protrusions that are arranged to improve the flatness of the substrate. A conventional wafer table1 is described by European patent application EP0947884 incorporated herein by reference. On the wafer table protrusions are arranged to improve the flatness of the substrate. These protrusions have a general diameter of 0.5 mm and are located generally at a distance of 3 mm away from each other and thereby form a bed of supporting members that support the substrate. For an electrostatic clamp as illustrated, typically, the height of the protrusions lies in the range 1 µm - 15 µm. In other arrangements, the wafer table may provide clamping by providing a vacuum pressure on the backside of an article (known as vacuum clamping). For this type of article support members, these protrusions generally have a height of 100 µm. Due to the relative large spaces in between the protrusions, contaminations possibly present generally do not form an obstruction for the flatness of the substrate, since these will be lying in between the protrusions and will not lift the substrate locally.

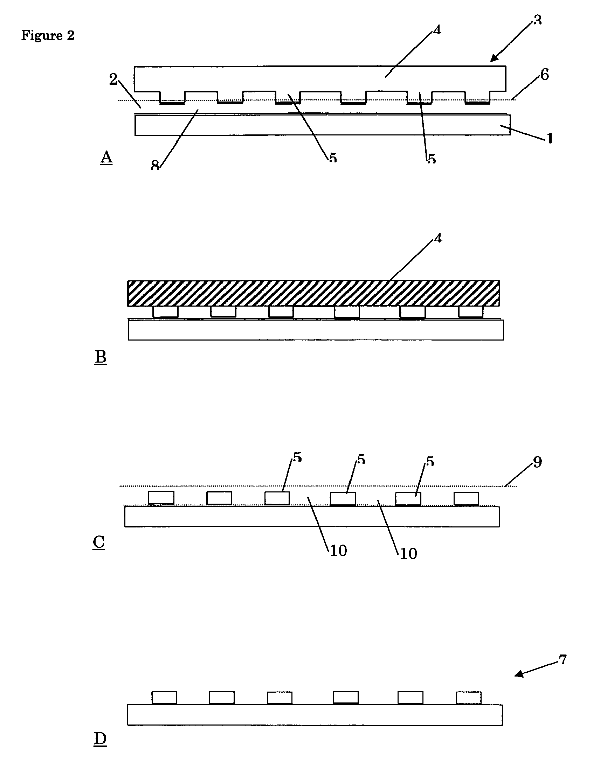

Figure 2 illustrates schematically the actions for manufacturing a multilayer structure according to the invention; specifically providing (see fig. A) a base plate 1 having a flat top surface 2; providing a burl plate 3 comprising a plate 4 having a plurality of burls 5 formed to provide a flat top surface 6; bonding said flat top surface of said burl plate 3 to said base plate 1; and removing (see fig. B and C) the plate 4 of the burl plate 3 thus leaving the burls 5 of the burl plate 3 bonded to the base plate 1 (see fig. C and D) and providing a article support member 7. In particular, the article support member 7 thus configured is able to support an article to be placed in a beam path of a radiation beam of a lithographic apparatus on said article support 7 and comprises a base plate 1 of a first material; and a plurality of burls 5 of a second material, bonded to said base plate of said first material.

Although in the description, the actions are numbered in consecutive order it will be understood that some of the actions may be carried out in parallel or in reverse order.

In particular, the bonding is carried out in a way that the stresses are kept within acceptable limits when joining the base plate 1 and burl plate 3, and can be provided by a bonding layer 8 which can be applied on one or either sides of the base plate 1 and/or burl plate 3.

By removing the plate 4 at a high temperature, for instance, substantially the same temperature where the bonding is carried out, stresses may be kept low. Otherwise, it stress zones may be formed in the burl plate 3. In another aspect, the bonding temperature can be kept as low as possible, for instance, by providing local thermal energy to the bonding spots, i.e. local spot welding. This could be done by providing an electric current through the burls 5. One aspect that can be considered of importance is, when the article support 7 is to be use in wet environments, for instance, for immersion lithographic purposes, that the bonds are corrosion resistant. Such bonds could be obtained for instance by glass fritting, which can be done by providing glass powder between the base plate 1 and burl plate 3 and heating it to a glass powder melting temperature.

Figure 2B illustrates that the plate 4 is to be removed from the burls 5 by indicating the plate as a greyed area. This can be done, depending on the materials, by a variety of techniques such as electro discharge machining, cutting, sanding or grinding or etching the plate to a desired extent. In this way, the burls 5, thus bonded to the base plate 1, are freed from their base plate and are provided a flat top surface 9

Figure 2C shows that the remaining bonding layer is removed in the areas 10 between the burls 5. This may be beneficial when the object support is used in a wet environment and metal zones should be shielded and reduced to a minimum.

In another aspect of the invention, it can be considered to improve the wear resistance of the base plate 1 itself, potentially, in combination with burls 5 provided in the base plate, as is conventionally done, as considered in contrast to the hereabove described invention. In such aspect, the previous described materials of the first group are materials having a Coefficient of Thermal Expansion of less then 0.05*E-6 K-1, in particular, these materials comprise Zerodur, ULE and/or Cordierite; and the previous described materials of the second group are materials having a fracture toughness (KIC) of more than 1.5 MPa m1/2, in particular, these materials comprise SiSiC and/or SiC.

For that matter, the materials having a practically zero CTE have less ideal fracture toughness (K_{IC}) of about 0.9-1.3, compared to a fracture toughness of 2.9 of SiSiC. Hence, it can be considered to increase the fracture toughness of Cordierite by doping it with LiNbO3 or ZrO2 in a vol fraction of at least 2% or generally with doping elements increasing the fracture toughness to at least a value of 1.5 MPa m1/2. Improving Corderiete material characteristics is discussed in previous publications, for instance JP application no 2000-375546.

Cordierite can be expressed by general formula of 2MgO.2Al2O3.5SiO2. The fracture toughness can then be increased to a value ranging above 2.0 MPa ml/2, which gives the material an expected lifetime of about the same as the materials of second group indicated hereabove.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. An article support member configured to support an article to be placed in a beam path of a radiation beam of a lithographic apparatus on said article support; said article support member comprising:
- a base plate of a first material; and
- a plurality of burls of a second material, bonded to said base plate of said first material.

2. An article support member according to claim 1, wherein said first material is of a non-expanding material; and wherein said second material is of a wear resistant material.

3. An article support member according to claim 1, wherein said first material is one of a first group of materials having a Coefficient of Thermal Expansion of less then 0.05*E-6 K⁻¹; and wherein said second material is one of a second group of materials having a fracture toughness (K_{IC}) of more than 1.5 MPa m^{½}.

4. An article support member according to claim 3, wherein said first group comprises Zerodur, ULE and Cordierite; and wherein said second group comprises SiSiC and SiC.

5. An article support member according to claim 1, wherein said burls are bonded to said base plate via a bonding layer.

6. An article support member according to claim 5, wherein said bonding layer is corrosion resistant.

7. An article support member according to claim 5, wherein said bonding layer is a metal layer used for spot welding/anodic bonding said burls.

8. A method of manufacturing an article support member, comprising:
- providing a base plate having a flat surface;
- providing a burl plate comprising a plate having a plurality of burls formed to provide a flat top surface;
- bonding said flat top surface of said burl plate to said base plate;
- and removing the plate of the burl plate thus leaving the burls of the burl plate bonded to the base plate.

9. Method according to claim 8, wherein said bonding is provided by glass fritting.

10. Method according to claim 8, wherein said bonding is provided by spot welding the burl plate using a metal coating on said base plate as a bonding layer.

11. Method according to claim 9, wherein said metal layer is removed after spot welding the burls.

12. A method of increasing a fracture toughness of Corderiete comprising doping Cordierite with LiNb03 and/or Zr02.

13. A wear resistant piece of Cordierite having fracture toughness of at least 1.5 mPa ml/2 and comprising a fraction of LiNbO3 and/or Zr02.

14. A wear resistant piece according to claim 13, wherein in the volume fraction of LiNbO3 and/or Zr02 is at least 2%.
